# EUROPÄISCHE PATENTANMELDUNG

(11) **EP 1 359 432 A2**
(43) Veröffentlichungstag der Anmeldung: **05.11.2003**
(21) Anmeldenummer: 03075314.9
(22) Anmeldetag: 03.02.2003
(51) Int. Cl.: G01S 7/282

(54) **Short-Range-Radarsystem mit variabler Pulsdauer**

(30) Priorität: 04.05.2002 DE 10220073
(71) Anmelder: ROBERT BOSCH GMBH, 70442 Stuttgart (DE)
(72) Erfinder: Steinbuch, Dirk, 71299 Wimsheim (DE)

(57) **Zusammenfassung**

Die Erfindung betrifft ein Short-Range-Radarsystem mit
- Short-Range-Radar Sensormitteln,
- Mitteln 41 zur HF-Impulserzeugung für die Sensormittel,
**dadurch gekennzeichnet, dass**
die Mittel zur HF-Impulserzeugung zur Abgabe von Impulsen mit einstellbarer Pulsdauer (51, 53) ausgebildet sind.

## Beschreibung

Die Erfindung betrifft ein Short-Range-Radarsystem nach dem Oberbegriff des Patentanspruchs 1 sowie ein Verfahren zum Betrieb eines Short-Range-Radarsystems.

Aus dem Stand der Technik sind Short-Range-Radarsysteme für verschiedene Automobilanwendungen bekannt. Die entsprechenden Radarsensoren arbeiten nach dem Puls-Echo-Prinzip: Ein elektromagnetischer Puls von ca. 400 ps Dauer wird von dem Radarsensor ausgesandt; in der Umgebung des Fahrzeugs trifft er zum Beispiel auf ein anderes Fahrzeug, eine Begrenzungsmauer oder ein anderes Hindernis. Der an dem Hindernis reflektierte Puls wird detektiert und ausgewertet. Die Laufzeit des Pulses und die Frequenzverschiebung aufgrund des Dopplereffekts sind die wesentlichen Messgrößen, aus denen Abstände und Relativgeschwindigkeiten bestimmt werden.

Im Nahbereich wird die Puls-Echo-Messung bei einer Mittenfrequenz von ca. 24 GHz betrieben. Dabei wird der Detektionsbereich um den Sensor in kugelförmige Schichten unterteilt, die als "Range Gates" bezeichnet werden. Diese "Range Gates" haben eine Breite von 20 cm und werden durch eine Pulsfolge abgetastet. Innerhalb von ca. 10 ms wird auf diese Art und Weise der gesamte Detektionsbereich im Fahrzeugumfeld vermessen.

Aus dem Stand der Technik bekannte Anwendungen für Short-Range-Radarsensorsysteme sind zum Beispiel die Einparkhilfe, Kollisionsvorhersage, Folgeverfahren, Spurwechselassistent und Adaptive Cruise Control. Entsprechende SRR Radar-Sensorsysteme sind von der Firma Robert Bosch GmbH, Stuttgart, kommerziell erhältlich.

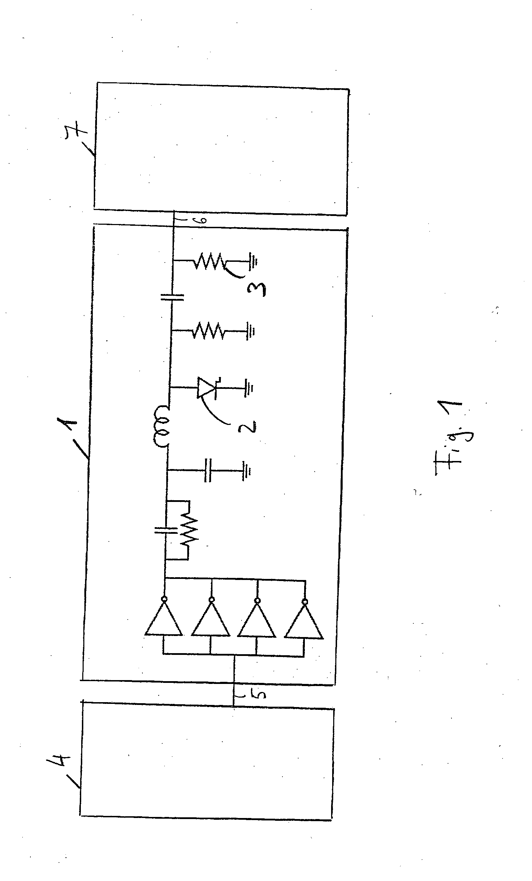

Die Figur 1 zeigt einen aus dem Stand der Technik bekannten HF-Impulserzeuger 1, wie er in kommerziell erhältlichen Short-Range-Radarsystemen der Firma Robert Bosch GmbH verwendet wird. Der HF-Impulserzeuger 1 basiert auf einer Step Recovery Diode 2. Der HF-Impulserzeuger 1 wird mit einem hochohmigen Widerstand 3 von zum Beispiel 1, 8 kΩ oder 2,7 kΩ abgeschlossen.

Wenn von einem Steuergerät 4 ein entsprechendes Steuersignal in den Eingang 5 des HF-Impulserzeugers 1 eingegeben wird, gibt dieser an seinem Ausgang 6 einen HF-Impuls einer vorgegebenen Pulsdauer von typischerweise 400 ps ab. Dieser HF-Impuls wird in den HF-Schalter 7 eingegeben.

Der hochohmige Widerstand 3 bewirkt, dass der Strom, den die Schalterdioden aufgrund der negativen Pulse gleichrichten, über diesen Widerstand eine positive Spannung bewirkt. Diese Spannung, die sogenannte Back-Bias-Spannung, sperrt die Dioden, solange kein Puls anliegt. Wird der negative Puls eingespeist, so wird zunächst die Back-Bias-Spannung überwunden und dann die Dioden durchgeschaltet.

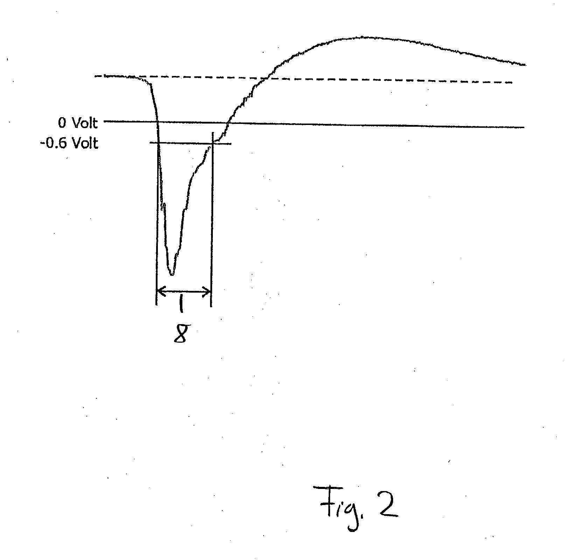

Die Figur 2 zeigt den Spannungsverlauf eines entsprechenden Impulses für einen Widerstand 3 von 2,7 kΩ. Die Dioden-Schaltschwelle beträgt -0,6 V, woraus sich die resultierende HF-Pulsbreite 8 ergibt.

Der Nahbereich um das Fahrzeug wird also mit einer festen HF-Pulsbreite 8 abgetastet. Die damit erreichbare Reichweite beträgt z.B. 7 m.

Der Erfindung liegt die Aufgabe zu Grunde ein Short-Range-Radarsystem mit einer vergrößerten Reichweite zu schaffen.

Die der Erfindung zu Grunde liegende Aufgabe wird mit den Merkmalen der unabhängigen Patentansprüche jeweils gelöst. Bevorzugte Ausführungsformen der Erfindung sind in den abhängigen Patentansprüchen angegeben.

Die Erfindung ermöglicht eine Erweiterung der Reichweite eines Short-Range-Radarsystems durch eine Veränderung der HF-Pulsbreite in Abhängigkeit von dem abgetasteten Entfernungsbereich. Dadurch lässt sich die maximale Reichweite eines Short-Range-Radarsystems auf zum Beispiel 14 m oder auch bis 30 m erhöhen.

Nach einer bevorzugten Ausführungsform der Erfindung erfolgt der Betrieb des Short-Range-Radarsystems in einem ersten Entfernungsbereich von zum Beispiel bis zum 7 m mit einer im wesentlichen festen HF-Pulsbreite, um in diesem Entfernungsbereich eine maximale Trennfähigkeit zu erhalten. In einem zweiten Entfernungsbereich von zum Beispiel 7 m bis 14 m wird die HF-Pulsbreite vergrößert.

Die Vergrößerung der HF-Pulsbreite hat eine vergrößerte Reichweite verbunden mit einer geringeren räumlichen Trennfähigkeit zur Folge. Die verringerte räumliche Trennfähigkeit in dem zweiten Entfernungsbereich ist jedoch nicht nachteilig, da aufgrund der größeren Entfernung von Hindernissen in dem zweiten Entfernungsbereich für die verschiedenen Fahrerassistenzsysteme auch nur eine geringere Trennfähigkeit erforderlich ist.

Nach einer weiteren bevorzugten Ausführungsform der Erfindung steigt die Pulsdauer in dem zweiten Entfernungsbereich im wesentlichen linear mit zunehmender Entfernung an.

Nach einer weiteren bevorzugten Ausführungsform der Erfindung werden HF-Pulse mit variabler HF-Pulsbreite erzeugt, indem der hochohmige Abschlusswiderstand bei einem aus dem Stand der Technik bekannten Step Recovery Dioden-Pulserzeuger durch einen niederohmigen Widerstand ersetzt wird. Die Back-Bias-Spannung wird durch ein externes Signal variiert. Durch Veränderung der Back-Bias-Spannung kann der Diodenschaltpunkt und damit die HF-Pulsbreite verändert werden.

Im Weiteren werden bevorzugte Ausführungsformen der Erfindung mit Bezugnahme auf die Zeichnungen näher erläutert. Es zeigen:
- Figur 1: ein Blockdiagramm eines aus dem Stand der Technik bekannten Short-Range-Radarsystems mit einem HF-Impulserzeuger,
- Figur 2: einen von dem HF-Impulserzeuger der Figur 1 erzeugten HF-Impuls,
- Figur 3: ein Flussdiagramm zur Veranschaulichung einer Ausführungsform des erfindungsgemäßen Verfahrens zum Betrieb eines Short-Range-Radarsystems,
- Figur 4: ein Blockdiagramm einer Ausführungsform des erfindungsgemäßen Short-Range-Radarsystems mit einem HF-Impulserzeuger zur Erzeugung von HF-Impulsen einstellbarer HF-Pulsbreite,
- Figur 5: HF-Impulse unterschiedlicher Pulsbreite, die von dem HF-Impulserzeuger der Figur 4 erzeugt werden.

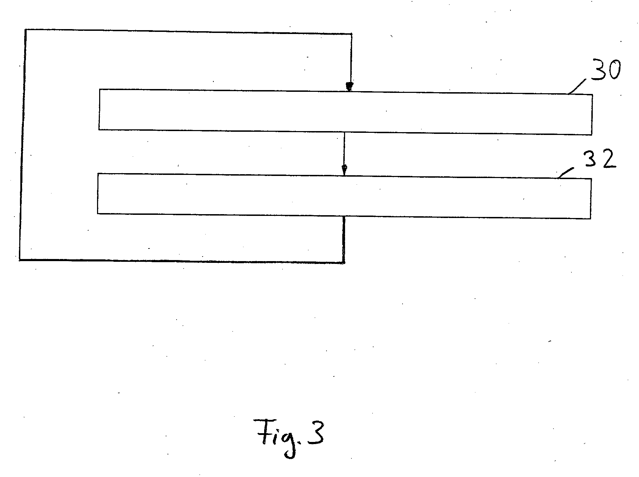

Die Figur 3 zeigt ein Flussdiagramm zum Betrieb eines Short-Range-Radarsystems. In dem Schritt 30 wird von dem Radarsensor des Short-Range-Radarsystems der Entfernungsbereich von 0 m bis 7 m in dem Detektionsbereich abgetastet. Dies erfolgt mit einer festen Impulsbreite von zum Beispiel 400 ps, wie es an sich aus dem Stand der Technik bekannt ist.

In dem Schritt 32 wird ein weiterer Entfernungsbereich von zum Beispiel 7 m bis 14 m von dem Short-Range-Radarsensor abgetastet. In diesem zweiten Entfernungsbereich erfolgt die Abtastung mit einer vergrößerten Impulsbreite. Zum Beispiel wird für den gesamten zweiten Abtastbereich eine feste längere Impulsbreite gewählt. Vorzugsweise wird die Impulsbreite innerhalb des zweiten Entfernungsbereichs variiert, zum Beispiel linear ansteigend mit zunehmender Entfernung.

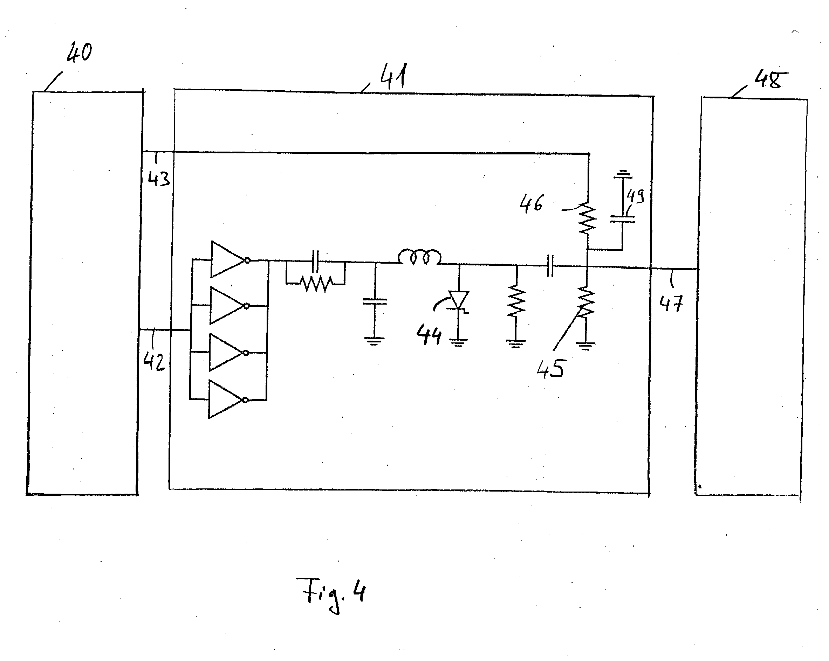

Die Figur 4 zeigt ein Blockdiagramm einer Ausführungsform eines erfindungsgemäßen Short-Range-Radarsystems. Das Short-Range-Radarsystem beinhaltet ein Steuergerät 40, das einen HF-Impulserzeuger 41 ansteuert. Der HF-Impulserzeuger 41 hat einen Eingang 42 zur Eingabe von Auslöse-Signalen von dem Steuergerät 40. Aufgrund eines solchen Auslöse-Signals erzeugt der HF-Impulserzeuger 41 einen HF-Impuls.

Der HF-Impulserzeuger 41 hat ferner einen Eingang 43, der ebenfalls mit dem Steuergerät 40 verbunden ist. Über den Eingang 43 kann die HF-Pulsbreite eingestellt werden.

Der HF-Impulserzeuger 41 basiert auf einer Step Recovery Diode 44, wie das auch bei dem aus dem Stand der Technik bekannten HF-Impulserzeuger 1 (vgl. Figur 1) der Fall ist. Im Unterschied zu dem HF-Impulserzeuger 1 ist der HF-Impulserzeuger 41 der Figur 4 durch einen niederohmigen Widerstand 45 abgeschlossen. Der Widerstand 45 hat einen Wert von zum Beispiel 50 Ω. Dadurch kann sich zunächst keine effektive Back-Bias-Spannung mehr aufbauen. Diese wird dagegen durch eine extern eingespeiste Spannung ersetzt, die über den Widerstand 46 an den Schaltereingang 47 des HF-Schalters 48 angelegt wird.

Durch Anlegen einer Steuerspannung an den Eingang 43 kann dann die effektive Back-Bias-Spannung zwischen 0 V und einer positiven Spannung variiert werden, wodurch die HF-Pulsbreite eingestellt wird. Dadurch, dass der Basisbandpuls nicht perfekt rechteckig ist, sondern eine Sägezahnform hat, kann man die Breitenunterschiede des Pulses ausnutzen und durch Veränderung der Back-Bias-Spannung den Diodenschaltpunkt und damit die HF-Pulsbreite verändern.

Vorzugsweise ist zwischen dem Eingang 47 und Masse ein Kondensator 49 zur Entstörung angeordnet.

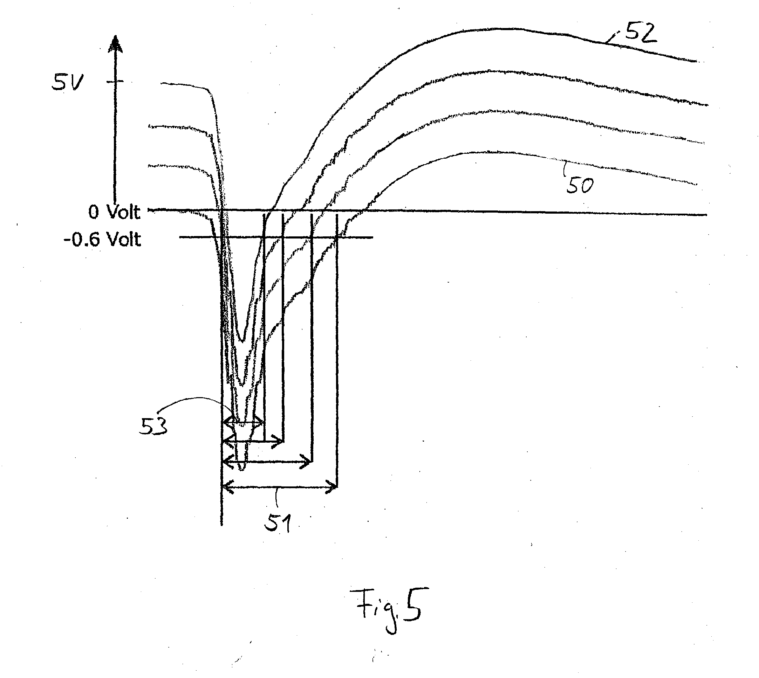

Die Figur 5 zeigt die entsprechenden Signalverläufe für unterschiedliche Werte der Back-Bias-Spannung für einen Widerstand 45 von 50 Ω und einer Dioden-Schaltschwelle von -0,6 V. Den Impuls 50 erhält man bei einer an dem Eingang 43 (vgl. Fig. 4) anliegenden Back-Bias-Spannung von 0 V. Daraus ergibt sich die HF-Pulsbreite 51. Bei einer maximalen am Eingang 43 anliegenden Back-Bias-Spannung von 5 V erhält man dagegen den Impuls 52 mit der HF-Pulsbreite 53, die weniger als die Hälfte der HF-Pulsbreite 51 beträgt. Zwischen den HF-Pulsbreiten 51 und 53 lässt sich also die HF-Pulsbreite durch entsprechende Veränderung der Back-Bias-Spannung an dem Eingang 53 einstellen.

In einem ersten Entfernungsbereich wird also zum Beispiel mit einer Back-Bias-Spannung von 5 V gearbeitet, um die kurze HF-Pulsbreite 53 von typischerweise 400 ps zu erhalten. Für den weiteren Entfernungsbereich von zum Beispiel 7 m bis 14 m wird dann die HF-Pulsbreite variiert, indem zum Beispiel für die Abtastung des Bereichs von 7 m bis 14 m die Back-Bias-Spannung allmählich abgesenkt wird. Bei der maximalen Entfernung von 14 m erreicht die Back-Bias-Spannung 0 V, so dass man die HF-Pulsbreite 51 erhält.

### Bezugszeichenliste

- HF-Impulserzeuger: 1
- Step-Recovery Diode: 2
- Widerstand: 3
- Steuergerät: 4
- Eingang: 5
- Ausgang: 6
- HF-Schalter: 7
- HF-Pulsbreite: 8
- Steuergerät: 40
- HF-Impulserzeuger: 41
- Eingang: 42
- Eingang: 43
- Step Recovery Diode: 44
- Widerstand: 45
- Widerstand: 46
- Eingang: 47
- HF-Schalter: 48
- Kondensator: 49
- Impuls: 50
- HF-Pulsbreite: 51
- Impuls: 52
- HF-Pulsbreite: 53

## Patentansprüche

1. Short-Range-Radarsystem mit
- Short-Range-RadarSensormitteln,
- Mitteln (41) zur HF-Impulserzeugung für die Sensormittel,
**dadurch gekennzeichnet, dass**
die Mittel zur HF-Impulserzeugung zur Abgabe von Impulsen mit einstellbarer Pulsdauer (51, 53) ausgebildet sind.

2. Short-Range-Radarsystem nach Anspruch 1, mit Mitteln (40, 43, 45, 46) zur Einstellung der Pulsdauer in Abhängigkeit des Detektionsbereichs.

3. Short-Range-Radarsystem nach Anspruch 2, bei dem die Mittel zur Einstellung der Pulsdauer so ausgebildet sind, dass die Pulsdauer für einen ersten Entfernungsbereich im wesentlichen konstant gehalten wird, und die Pulsdauer für einen zweiten Entfernungsbereich außerhalb des ersten Entfernungsbereichs variiert wird.

4. Short-Range-Radarsystem nach Anspruch 3, wobei die Mittel zur Einstellung der Pulsdauer so ausgebildet sind, dass die Pulsdauer in dem zweiten Entfernungsbereich mit zunehmender Entfernung ansteigt, wobei der Anstieg im Wesentlichen linear ist.

5. Short-Range-Radarsystem nach einem der vorhergehenden Ansprüche 1 bis 4, wobei die Mittel zur HF-Impulserzeugung einen Step Recovery Dioden-Pulserzeuger (41) aufweisen und Mittel (43, 45, 46) zur Einstellung der Back-Bias-Spannung.

6. Short-Range-Radarsystem nach Anspruch 5, mit einem niederohmigen Abschlusswiderstand (45).

7. Verfahren zum Betrieb eines Short-Range-Radarsensors mit folgenden Schritten:
- Betrieb des Short-Range-Radarsensors mit einer im wesentlichen festen HF-Impulsbreite in einem ersten Entfernungsbereich,
- Betrieb des Short-Range-Radarsensors mit einer variablen HF-Impulsbreite in einem zweiten Entfernungsbereich außerhalb des ersten Entfernungsbereichs.

8. Verfahren nach Anspruch 7, wobei die HF-Impulsbreite in dem zweiten Entfernungsbereich mit zunehmender Entfernung vergrößert wird.

9. Verfahren nach Anspruch 8, wobei die Vergrößerung der Impulsbreite in dem zweiten Entfernungsbereich im wesentlichen linear mit zunehmender Entfernung erfolgt.

10. Verfahren nach einem der vorhergehenden Ansprüche 7, 8 oder 9, wobei für die HF-Impulserzeugung ein Step Recovery Dioden-Pulserzeuger verwendet wird, der mit einem niederohmigen Widerstand abgeschlossen ist, wobei die Einstellung der HF-Impulsbreite durch Einstellung der Back-Bias-Spannung erfolgt.
